# EUROPEAN PATENT APPLICATION

(11) **EP 2 273 558 A1**
(43) Date of publication of application: **12.01.2011**
(21) Application number: 09730405.9
(22) Date of filing: 26.02.2009
(51) Int. Cl.: H01L 31/04

(54) **SOLAR BATTERY CELL MANUFACTURING METHOD, SOLAR BATTERY MODULE MANUFACTURING METHOD, AND SOLAR BATTERY MODULE**

(30) Priority: 08.04.2008 JP 2008100497
(71) Applicant: Sharp Kabushiki Kaisha, Osaka-shi, Osaka 545-8522 (JP)
(72) Inventor: FUNAKOSHI, Yasushi, Osaka-shi, Osaka 545-8522 (JP)
(74) Representative: Müller - Hoffmann & Partner
(86) International application number: PCT/JP2009/053523
(87) International publication number: WO 2009/125628

(57) **Abstract**

With screen printing, an N electrode (10) electrically connected to an N+ layer (4) is formed on a passivation film (5), and a P electrode contact (8) electrically connected to a P+ layer (3) is formed. Then, with screen printing, an insulating layer (11) is formed to cover a surface of the N electrode (10) and expose a surface of the P electrode contact (8). After that, with screen printing, a P electrode (9) electrically connected to the P electrode contact (8) is formed on the insulating layer (11).

## Description

### TECHNICAL FIELD

The present invention relates to a method for manufacturing a solar cell, a method for manufacturing a solar cell module, and a solar cell module, and more particularly to a method for manufacturing a solar cell including layered electrodes, a solar cell module having such solar cells connected in series, and a method for manufacturing thereof.

### BACKGROUND ART

In recent years, development of clean energy sources has been desired against the backdrop of the problem of exhaustion of energy resources or global environmental problems due to increase in greenhouse gases typified by CO₂ in the atmosphere. Solar power generation using solar batteries (cells, modules), particularly, has been developed and practically utilized as one of such energy sources, making continued progress.

Conventional solar cells mostly employ a single crystalline or polycrystalline silicon substrate of one conductivity type. In this type of solar cell, an impurity of the opposite conductivity type is diffused into a light-receiving surface of the silicon substrate of one conductivity type to form a p-n junction, and an electrode is formed on each of the light-receiving surface and a back surface of the silicon substrate. Also developed is a solar cell in which a silicon substrate of one conductivity type includes an impurity layer containing a high concentration of impurity of the same conductivity type formed in a back surface of the silicon substrate, thereby achieving high output owing to a back surface electric field effect.

A so-called back surface junction type solar cell (or a back surface electrode type solar cell) in which an electrode is not formed on a light-receiving surface of a silicon substrate and a p-n junction is formed in a back surface of the silicon substrate has also been developed (see Japanese National Patent Publication No. 2006-523025 (Patent Document 1), United States Patent No. 4,234,352 (Patent Document 2)). Since an electrode is not formed on the light-receiving surface, this kind of back surface junction type solar cell does not have shadow loss caused by the electrode, and is expected to obtain higher output than a solar cell including an electrode on each of a light-receiving surface and a back surface of a silicon substrate.
Patent Document 1: Japanese National Patent Publication No. 2006-523025
Patent Document 2: United States Patent No. 4,234,352

### DISCLOSURE OF THE INVENTION

### PROBLEMS TO BE SOLVED BY THE INVENTION

The conventional solar cells (modules) suffer from the following problems, however. First, the back surface electrode type solar cell includes all of a P+ layer, an N+ layer, a P type electrode, and an N type electrode in/on a back surface of the solar cell, resulting in a complicated structure of the solar cell. Additionally, since this type of solar cells are connected in series to manufacture a solar cell module, busbar electrodes for the P type electrode and the N type electrode must be provided on opposing ends of the solar cell.

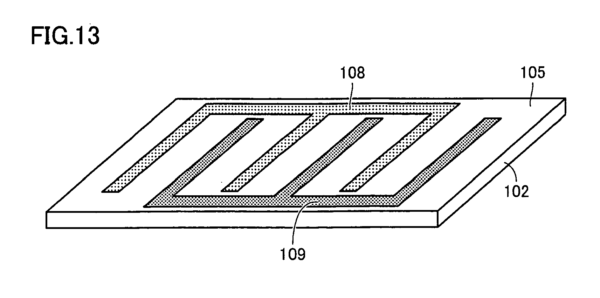

For this reason, a finger electrode needs to have a length substantially the same as a width of a silicon substrate of the solar cell, resulting in an increased value of a flowing current per finger electrode. As shown in Fig. 13, a P type electrode 108 and an N type electrode 109 exposed at a surface of a silicon substrate 102 covered with a passivation film 105 are formed like teeth of a comb, and provided facing each other with their teeth being interdigitated with one another.

For this reason, a line width of a finger electrode needs to be designed such that the P type electrode and the N type electrode do not contact each other. Without a sufficient line width, however, a F.F (Fill Factor) decreases due to a series resistance component, resulting in reduced output of the solar cell. The F.F. is a parameter that represents inclination of a current-voltage characteristic curve as a solar cell, and is defined as a value obtained by dividing maximum power by the product of an open-circuit voltage and a short circuit current.

Patent Document 2 proposes a structure including two layers of a P type electrode and an N type electrode, with a silicon oxide film interposed between the two layers as an insulating layer. This structure is described as having an effect of back surface reflection of a solar cell. By forming the P type electrode and the N type electrode on substantially the entire back surface of the solar cell based on this structure, electrical resistance of the P(N) type electrode(s) can be reduced, thereby obtaining a high F.F.

Unfortunately, in this solar cell, the P type electrode, the N type electrode, and the insulating layer are formed through photolithography steps and a vacuum process such as a vacuum evaporation method. This requires complicated steps and increases manufacturing costs, which renders this solar cell unsuitable for mass production. Additionally, if a busbar is used when connecting the solar cells in series to manufacture a solar cell module, a F.F decreases.

The present invention was made to solve the problems described above, and an object of the present invention is to provide a method for manufacturing a solar cell applicable to mass production by a simpler process and the solar cell, another object is to provide a method for manufacturing a solar cell module which ensures a F.F. by using such solar cells, and still another object is to provide such solar cell module.

### MEANS FOR SOLVING THE PROBLEMS

A method for manufacturing a solar cell according to the present invention includes the following steps. A first electrode is formed on a main surface of a silicon substrate by supplying a conducting material. An insulating layer is formed on a surface of the first electrode by applying an insulating material. A second electrode is formed on a surface of the insulating layer in a manner electrically isolated from the first electrode by supplying a conducting material.

With this method, the first electrode and the second electrode are formed by supplying the conducting material, and the insulating layer is formed by applying the insulating material. Therefore, the electrodes and the insulating layer are formed in a much simpler manner as compared to a case where photolithography and a vacuum process are used. This facilitates application to mass production, and reduces production costs.

Specifically, in the step of forming the insulating layer, one of a screen printing method, an offset printing method, and an ink-jet printing method is preferably applied.

In order to ensure insulation properties of the insulating layer, the step of forming the insulating layer preferably includes, after the application of the insulating material, the step of heating the applied insulating material or the step of curing the applied insulating material by ultraviolet irradiation.

A heating temperature in the heating step is preferably set to 150°C or more and 600°C or less.

This is because if the heating temperature is less than 150°C, a solvent contained in the applied insulating material cannot be removed, and if the heating temperature is more than 600°C, a crack occurs in the insulating layer and the insulation properties cannot be ensured.

Specifically, the insulating material preferably includes at least one of acryl, epoxy, polyimide, a polyimide precursor, and polyamide-imide.

In at least one of the step of forming the first electrode and the step of forming the second electrode, one of a screen printing method, an offset printing method, and an ink-jet printing method is preferably applied.

At least one of the step of forming the first electrode and the step of forming the second electrode preferably includes the step of applying a silver paste as the insulating material, and heating the applied silver paste.

It is preferable that the step of forming the first electrode include a first heating step of heating the supplied conducting material, that the step of forming the second electrode include a second heating step of heating the supplied conducting material and the first electrode heated in the first heating step, and that a temperature in the second heating step be set to 150°C or more and 600°C or less.

A method for manufacturing another solar cell according to the present invention includes the following steps. A first electrode is formed on a main surface of a silicon substrate by applying and heating a conducting material, the first electrode being electrically connected to a prescribed region in the silicon substrate,. An insulating layer is formed on a surface of the first electrode by applying and heating an insulating material. A second electrode is formed on a surface of the insulating layer by applying and heating a conducting material, the second electrode being electrically isolated from the first electrode and electrically connected to another prescribed region in the silicon substrate,.

With this method, the first electrode and the second electrode are formed by applying and heating the conducting material, and the insulating layer is formed by applying the insulating material. Therefore, the first electrode, the second electrode, and the insulating layer are formed in a much simpler manner as compared to a case where photolithography and a vacuum process are used. This facilitates application to mass production, and reduces production costs.

In at least one of the step of forming the first electrode, the step of forming the second electrode, and the step of forming the insulating layer, one of a screen printing method, an offset printing method, and an ink-jet printing method is preferably applied.

In the step of forming the first electrode, a second electrode contact portion electrically connected to the another prescribed region may be simultaneously formed, and in the step of forming the second electrode, the second electrode may be formed to be electrically connected to the second electrode contact portion.

In order to lower a heating temperature during formation of the second electrode, it is preferable that in the step of forming the second electrode, a silver paste be applied as the conducting material, and that the silver paste contain only an organic ingredient except silver.

A solar cell according to the present invention includes a first electrode, an insulating layer, and a second electrode. The first electrode is formed on a main surface of a rectangular silicon substrate. The insulating layer is formed on a surface of the first electrode to expose a surface of a portion of a region of the first electrode along a prescribed first side of the rectangular silicon substrate. The second electrode is formed on a surface of the insulating layer in a manner electrically isolated from the first electrode. The insulating layer includes at least one material selected from the group consisting of acryl, epoxy, polyimide, a polyimide precursor, and polyamide-imide.

According to this solar cell, a plurality of the solar cells can be connected in series by electrically connecting the portion of the region of the first electrode of one solar cell to the portion of the second electrode of another solar cell.

In a method for manufacturing a solar cell module having the solar cells manufactured by the method for manufacturing a solar cell according to any of claims 1 to 12 connected in series according to the present invention, a rectangular silicon substrate is used as the silicon substrate, and in the step of forming the insulating layer in each of the plurality of solar cells, the insulating layer is formed on a surface of the first electrode to expose a surface of a portion of a region of the first electrode along a prescribed first side of the rectangular silicon substrate, the method includes a string formation step of forming a first solar cell string and a second solar cell string by connecting a prescribed number of the solar cells in series, respectively, and a string connection step of connecting the first solar cell string to the second solar cell string in series. In the string formation step, a first solar cell located at an end in the first solar cell string and a second solar cell located at an end in the second solar cell string are arranged such that the first side of the first solar cell faces a third side or a fourth side other than a second side facing the first side of the second solar cell. In the string connection step, a portion of a region of the first electrode positioned along the first side of the first solar cell is electrically connected to a portion of the second electrode positioned along the third side or the fourth side of the second solar cell by means of a prescribed conducting member.

According to this structure, in the first solar cell string and the second solar cell string, the portion of the region of the first electrode positioned along the first side of the first solar cell is electrically connected to the portion of the second electrode positioned along the third side or the fourth side of the second solar cell by means of the prescribed conducting member. Therefore, a conducting member the same as the conducting member for electrically connecting the solar cells in the first solar cell string or the second solar cell string can be used as that conducting member. As a result, reduction in F.F caused by use of a busbar can be prevented.

Another solar cell module according to the present invention is a solar cell module including a plurality of solar cell strings each having a plurality of solar cells connected in series. Each of the plurality of solar cells includes a first electrode, an insulating layer, and a second electrode. The first electrode is formed on a main surface of a rectangular silicon substrate. The insulating layer is formed on a surface of the first electrode to expose a surface of a portion of a region of the first electrode along a prescribed first side of the rectangular silicon substrate. The second electrode is formed on a surface of the insulating layer in a manner electrically isolated from the first electrode. In a first solar cell string and a second solar cell string adjacent to each other of the plurality of solar cell strings, a first solar cell located at an end in the first solar cell string and a second solar cell located at an end in the second solar cell string are arranged such that the first side of the first solar cell faces a third side or a fourth side other than a second side facing the first side of the second solar cell. A portion of a region of the first electrode positioned along the first side of the first solar cell is electrically connected to a portion of the second electrode positioned along the third side or the fourth side of the second solar cell by means of a prescribed conducting member.

According to this structure, the portion of the region of the first electrode positioned along the first side of the first solar cell is electrically connected to the portion of the second electrode positioned along the third side or the fourth side of the second solar cell by means of a prescribed conducting member. Therefore, a conducting member the same as the conducting member for electrically connecting the solar cells in the first solar cell string or the second solar cell string can be used as that conducting member. As a result, reduction in F.F caused by use of a busbar can be prevented.

### BRIEF DESCRIPTION OF THE DRAWINGS

Fig. 1 is a perspective view showing a step of a method for manufacturing a solar cell according to a first embodiment of the present invention.
Fig. 2 is a partial cross-sectional view in the step shown in Fig. 1 according to the same embodiment.
Fig. 3 is a perspective view showing a step performed after the step shown in Fig. 1 according to the same embodiment.
Fig. 4 is a partial cross-sectional view in the step shown in Fig. 3 according to the same embodiment.
Fig. 5 is a perspective view showing a step performed after the step shown in Fig. 3 according to the same embodiment.
Fig. 6 is a partial cross-sectional view in the step shown in Fig. 5 according to the same embodiment.
Fig. 7 is a perspective view showing a step performed after the step shown in Fig. 5 according to the same embodiment.
Fig. 8 is a partial cross-sectional view in the step shown in Fig. 7 according to the same embodiment.
Fig. 9 illustrates evaluation of insulating layers after being heated according to the same embodiment.
Fig. 10 is a plan view showing an example of connection among solar cells in a solar cell module according to a second embodiment of the present invention.
Fig. 11 is a plan view showing a preferable example of connection among the solar cells in the solar cell module according to the same embodiment.
Fig. 12 is a cross-sectional view showing the solar cell module according to the same embodiment.
Fig. 13 is a perspective view showing an example of a conventional solar cell.

### DESCRIPTION OF THE REFERENCE SIGNS

1 solar cell; 2 silicon substrate; 3 P+ layer; 4 N+ layer; 5 passivation film; 6 contact hole; 7 antireflection coating; 8 P electrode contact; 9 P electrode; 10 N electrode; 11 insulating layer; 21 solar cell string; 22 conducting member; 23 busbar; 24 external terminal; 31 solar cell module; 32 translucent sealant; 33 weather-resistant film; 34 translucent substrate; 35 terminal box; 36 frame.

### BEST MODES FOR CARRYING OUT THE INVENTION

### First Embodiment

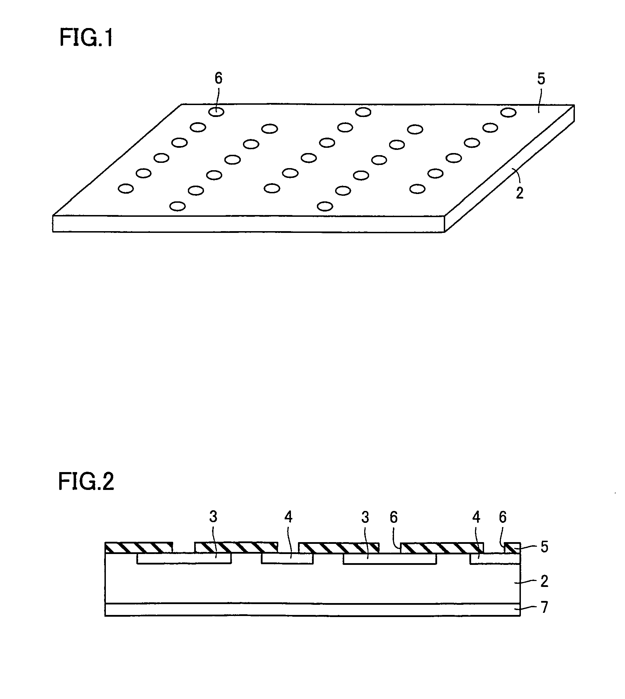

A method for manufacturing a solar cell is described. First, as shown in Figs. 1 and 2, a P+ layer 3 and an N+ layer 4 are alternately formed in lines, for example, in a back surface (face opposite to a light-receiving surface) of a silicon substrate 2. Then, a passivation film 5 is formed to cover the back surface. Contact holes 6 through which surfaces of P+ layer 3 and N+ layer 4 are exposed are formed in passivation film 5. Contact holes 6 can be formed in dots or in lines by printing and heating a paste with which passivation film 5 can be etched into a desired shape. An antireflection coating 7 is formed in the light-receiving surface of silicon substrate 2.

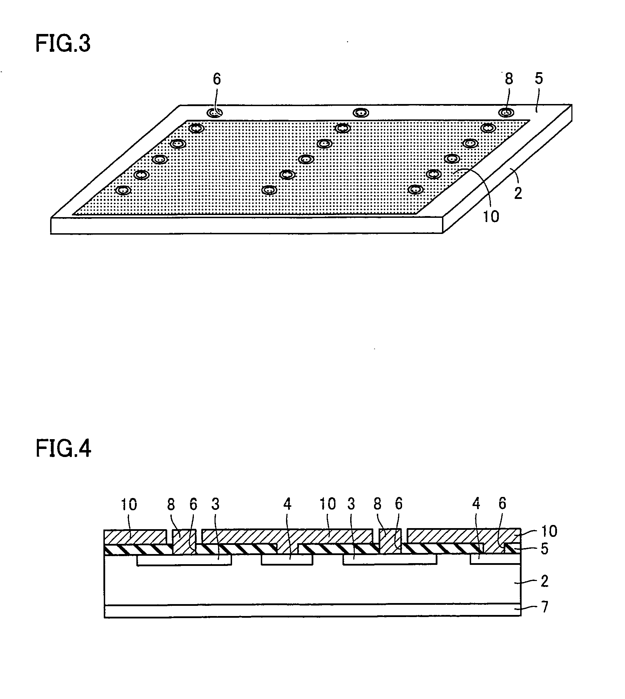

Next, as shown in Figs. 3 and 4, an N electrode (first layer electrode) 10 electrically connected to N+ layer 4 is formed on passivation film 5, and a P electrode contact 8 electrically connected to P+ layer 3 is formed. P electrode contact 8 is formed to project from contact hole 6 provided in passivation film 5. N electrode 10 is formed in a region other than regions of contact holes 6, to prevent an electrical short with P electrode contact 8. Although only N electrode 10 may be formed, it is preferable to simultaneously form P electrode contact 8, as will be described later.

N electrode 10 and P electrode contact 8 are formed by using a paste mainly composed of metal. In order to obtain a high degree of contact with silicon substrate 2 and keep resistivity of the electrodes themselves low, it is preferable to use a paste mainly composed of silver or a paste containing a glass frit. This paste which becomes the electrodes is applied by screen printing. A method for applying the paste which becomes the electrodes includes, in addition to screen printing, offset printing, ink-jet printing, and the like.

The applied paste is then heated. Here, it is important to heat the paste to a sufficient degree. This is because if an organic ingredient contained in the paste which becomes the electrodes is not vaporized to a sufficient degree, an insulating layer to be subsequently formed will have bulges and holes, which may cause conduction between two electrodes positioned with the insulating layer interposed therebetween. For this reason, it is preferable to perform the heating process at a temperature of at least 150°C or more, and more preferable to fire the paste at an elevated temperature of 400°C or more, to obtain contact between the paste which becomes the electrodes and silicon substrate 2.

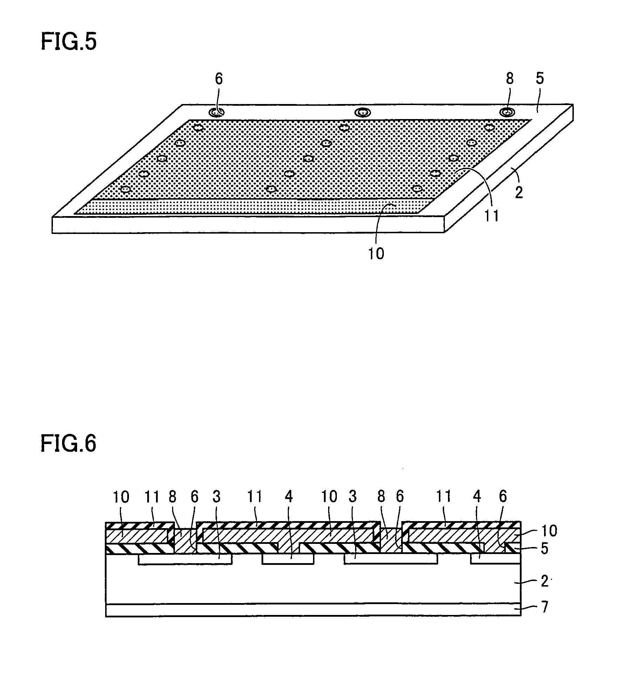

Next, as shown in Figs. 5 and 6, an insulating layer 11 is formed to cover a surface ofN electrode 10 and expose a surface of P electrode contact 8 by screen printing. Insulating layer 11 is formed by applying a paste which is mainly composed of a substance that exhibits electrical insulation properties, and which has a printable viscosity adjusted by a solvent, a thickener, or the like.

Examples of the substance having electrical insulation properties as the main ingredient of the paste include an inorganic material such as silica and alumina, or a resin material such as acryl, epoxy, polyimide, a polyimide precursor, and polyamide-imide. With only the inorganic material, an elevated temperature of approximately 1000°C is required in order to make a thin and flat insulating layer. With the resin material, on the other hand, the insulating layer is formed like a film due to a heating process of 400°C or less or ultraviolet (UV) irradiation, resulting in difficulty in forming a pin hole. It is therefore preferable that the paste be mainly composed of the resin material. The inorganic material may be added to the resin material to provide higher heat resistance. Namely, it is preferable that the insulating paste contain at least one type of the resin materials such as acryl, epoxy, polyimide, a polyimide precursor, and polyamide-imide.

Of the resin materials, polyimide, a polyimide precursor, polyamide-imide and the like have relatively high heat resistance for a resin material, and are thus effective when a process at 200°C or more is required. Acryl and epoxy have lower heat resistance than that of the polyimide-based materials but come in a variety of types such as a thermosetting type and a UV setting type, and are thus effective when a process at 200°C or more is not required after the insulating layer has been formed. Examples of a polyimide-based paste include HL-P series manufactured by Hitachi Chemical Company, Ltd., and examples of an acryl-, epoxy-based paste include UVR-150 series manufactured by Taiyo Ink Mfg. Co., Ltd.

Here, a polyimide-based paste was used because the paste would be heated at a temperature of approximately 400°C or more during formation of a P electrode which will be described later. When a polyimide-based paste is used, a solvent ingredient contained in printed insulating layer 11 is vaporized by heating insulating layer 11 at a temperature of 200°C or more, so that insulating layer 11 is formed like a flat film. When a polyimide precursor is used as the paste, the polyimide precursor is imidized as a result of this heating. A method for applying the paste which becomes the insulating layer includes, in addition to screen printing, offset printing, ink-jet printing, and the like.

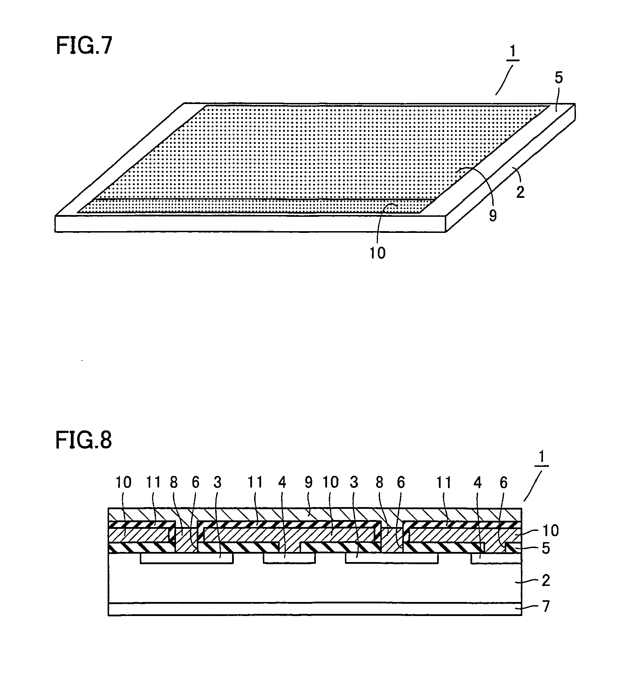

Next, as shown in Figs. 7 and 8, a P electrode 9 electrically connected to P electrode contact 8 is formed on insulating layer 11 by screen printing. As with N electrode 10, P electrode 9 is formed by using a paste mainly composed of metal. The applied paste is then fired by performing a prescribed heating process, to complete a solar cell including P electrode 9 and N electrode 10. A method for forming the electrodes includes, in addition to screen printing, offset printing, ink-jet printing, and the like.

The heating process on P electrode 9 is performed with insulating layer 11 being interposed between N electrode 10 and P electrode 9. Thus, heat resistance of insulating layer 11 was examined. Temperatures at which polyimide and a simple polyamide-imide start to be thermally decomposed are generally approximately from 400 to 500°C, although slightly varying with product, with a temperature of thermal decomposition of polyimide being slightly higher.

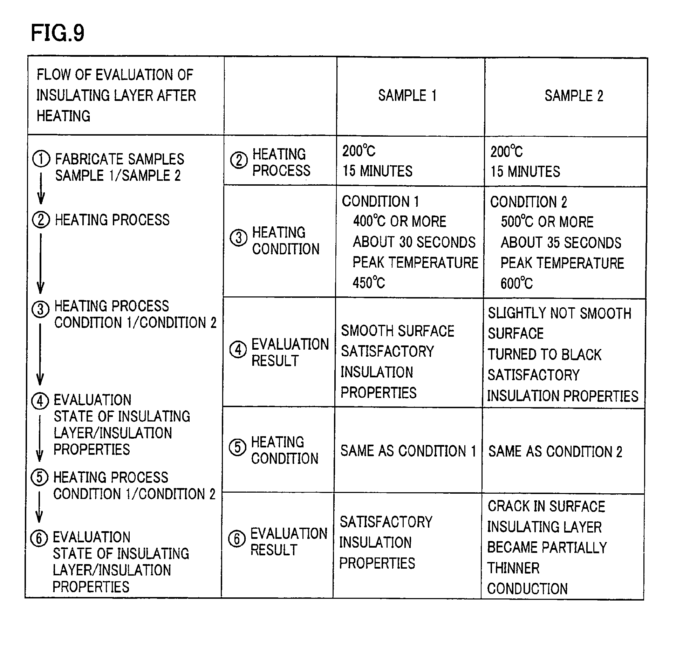

Accordingly, an insulating paste of the HL-P500 manufactured by Hitachi Chemical Company, Ltd. described above, which alters to polyimide when heated, was directly printed on a silicon substrate, heated for about 15 minutes at a temperature of 200°C, further heated thereafter under an electrode firing condition, and insulation properties after the heating were evaluated. Fig. 9 illustrates a flow of evaluation and its contents.

A sample 1 was first subjected to the heating process for about 15 minutes at a temperature of 200°C, and then to a heating process under a heating condition 1 (peak temperature 450°C, about 30 seconds at a temperature of 400°C or more). Observation of the insulating layer after this heating process showed that its surface was smooth and brown peculiar to polyimide.

A sample 2 was first subjected to the heating process for about 15 minutes at a temperature of 200°C, and then to a heating process under a heating condition 2 (peak temperature 600°C, about 35 seconds at a temperature of 500°C or more). Observation of the insulating layer after this heating process showed that its surface was slightly not smooth and had turned black. It was confirmed that at this point in time, the insulation properties of both sample 1 and sample 2 were satisfactory even after application of a voltage of 10V/µm. It is therefore considered that black discoloration in sample 2 was due to occurrence of thermal decomposition only on the surface of the insulating layer.

Subsequently, sample 1 was subjected to a heating process under the same condition as condition 1, and sample 2 was subjected to a heating process under the same condition as condition 2. In sample 2, observation of the surface of the insulating layer after the heating processes found that a crack had occurred in the insulating layer, and that the insulating layer had partially become thinner to expose the base silicon substrate. It was confirmed that the insulation properties were lost and conduction was effected in sample 2. In contrast, the insulation properties of sample 1 were satisfactory even after application of a voltage of 10V/µm.

These evaluation results showed that a heating condition for insulating layer 11 had an upper limit of a period of 35 seconds at a temperature of 500°C or more. Then, based on these evaluation results, P electrode 9 was formed by using a silver paste that can be fired under a heating condition similar to condition 1. Since this silver paste contains only a resin ingredient other than silver powders, a value of electrical resistivity would be sufficiently low even after heating at a temperature lower than that of condition 1. However, such heating results in higher contact resistance with the silicon substrate. Additionally, since this silver paste provides low electrical resistance even after heated at 200°C or less, an acryl- or epoxy-based insulating paste can also be used. However, heating at 200°C or less takes a very long time for heating. Thus, the paste was fired under a heating condition similar to condition 1.

Therefore, during actual manufacture, P electrode contact 8 and P electrode 9 were formed in separate steps, N electrode 10 and P electrode contact 8 were formed under a heating condition similar to condition 2, and P electrode 9 was formed under a heating condition similar to condition 1.

It should be noted that, because the insulation properties were satisfactory after heating under condition 2 only once, a method of using a paste capable of obtaining favorable contact with silicon to print and dry N electrode 10, then print and dry the insulating layer, then print and dry P electrode 9 with the paste, and then fire them together under condition 2 can be employed, thereby further simplifying the process.

With the manufacturing method above, N electrode 10, P electrode 9, and insulating layer 11 are formed by screen printing, and thus can be formed more simply with reduced manufacturing costs as compared to a case where they are formed through photolithography steps and a vacuum process.

The manufacturing method above has been described with an example of a back surface junction type solar cell including a P+ layer and an N+ layer on the side of a back surface of the solar cell. The manufacturing method above is applicable to a solar cell including a P+ electrode and an N+ electrode on one surface of the solar cell.

The method for forming the electrodes and the method for forming the insulating layer have been described with an example of screen printing. Screen printing uses a paste of high viscosity, and allows printing with a line width of approximately 100 µm, with a printing height of approximately several tens of µm with respect to a line width of approximately 100 µm. A screen printing apparatus is also relatively simple and has a high processing speed.

In addition to screen printing, offset printing and ink-jet printing may be applied, as described above. Offset printing uses a paste of low viscosity, and allows printing with a line width of approximately several tens of µm, with a printing height of approximately several µm. Ink-jet printing uses a paste of low viscosity, and allows printing with a line width of approximately ten to several tens of µm, with a printing height of approximately several µm.

As such, offset printing and ink-jet printing allow high definition printing as compared to screen printing, but are not suitable for thick application. Screen printing is capable of thick application, although with a slightly larger line width (approximately 100 µm), and is thus often used for mass production.

In the solar cell described above, N electrode 10 and P electrode 9 are formed on substantially the entire surface of solar cell 1, which leads to a larger cross-sectional area of the electrodes than in the past. Accordingly, the electrodes need not be as thick as conventional electrodes, and offset printing and ink-jet printing less suitable for thick printing than screen printing can be applied. Offset printing and ink-jet printing can also be applied to the step of forming contact hole 6 in passivation film 5 and the step of forming insulating layer 11, by adjusting the viscosity of the paste.

The electrodes may be formed by a plating method, for example, in addition to printing such as screen printing, although the process becomes slightly more complicated than printing. With a plating method, an electrode surface becomes flatter than an electrode surface formed by printing a paste. Another advantage is that a temperature of a heating condition for forming an electrode can be lower than a temperature of a heating condition for firing a paste.

### Second Embodiment

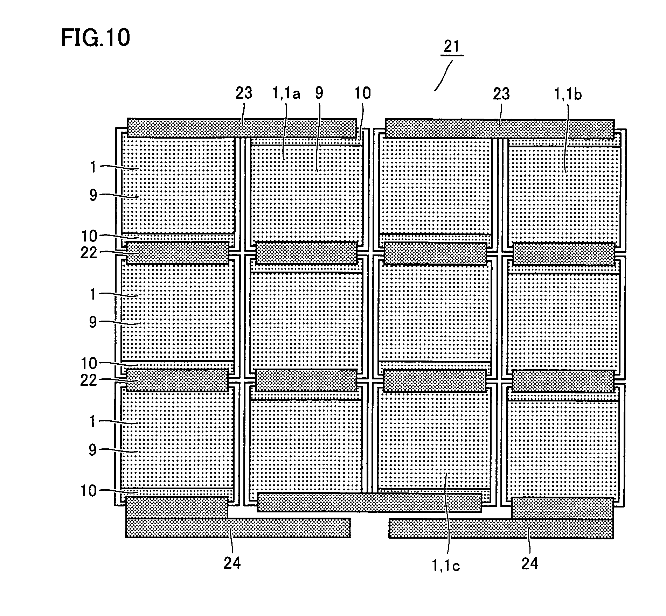

A method for manufacturing a solar cell module by using the solar cells fabricated in the previous embodiment is described. As shown in Fig. 7, manufactured solar cell 1 has a rectangular shape, with N electrode 10 being exposed along one of four sides, and P electrode 9 being exposed in the remaining region. As shown in Fig. 10, a plurality of solar cells 1 are connected in series by electrically connecting N electrode 10 of one solar cell 1 to P electrode 9 of another solar cell by means of a conducting material including a copper foil, for example, to form a solar cell string 21.

In solar cell string 21 shown in Fig. 10, three solar cells 1 are connected in series in one direction to form one solar cell string, and four solar cell strings are arranged in a direction orthogonal to the one direction. P electrode 9 of a solar cell in one solar cell string is electrically connected to N electrode 10 of a solar cell in an adjacent solar cell string by means of a busbar 23.

Of solar cells 1 in the solar cell strings shown in Fig. 10 (comparative example), it is preferable to rotate solar cells 1a, 1b, and 1c by 90° so that N electrode 10 is positioned along P electrode 9 of adjacent solar cell 1. As a result, P electrode 9 of a solar cell in one solar cell string can be electrically connected to N electrode 10 of a solar cell in an adjacent solar cell string by means of a conducting material 22, thus eliminating the need to attach a busbar.

When a busbar is applied, it is difficult to ensure a sufficient width of the busbar in terms of design of a solar cell module. Thus, resistance loss in the busbar may result in reduction in F.F. By not applying a busbar, therefore, reduction in F.F after a solar cell module has been formed can be minimized, thereby obtaining high output. In addition, since this solar cell 1 does not include an electrode on the side of the light-receiving surface, change in orientation of solar cells 1 poses no problem in terms of appearance.

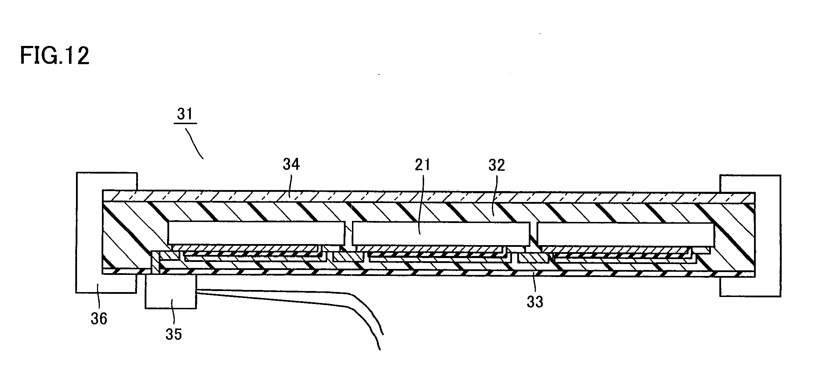

Next, solar cell string 21 thus formed is inserted into a thermoplastic translucent sealant (EVA: Ethylene Vinyl Acetate) 32. Then, a translucent substrate 34 such as a glass is provided on the side of the light-receiving surface of solar cell string 21, and a weather-resistant film 33 is provided on the back surface (see Fig. 12). A heating process is then performed to seal solar cell string 21 in translucent sealant 32, as shown in Fig. 12. After that, a prescribed terminal box 35 is connected and a frame 36 is attached, to complete a solar cell module 31. Terminal box 35 incorporates a bypass diode for external connection and for prevention of application of an excessive reverse voltage.

### First Example

A method for manufacturing a solar cell and a solar cell module as an example is described.

First, as a solar cell, a solar cell including P+ layer 3 and N+ layer 4 formed in a back surface of a silicon substrate, passivation film 5 covering the back surface, and antireflection coating 7 formed in a light-receiving surface of the silicon substrate was prepared. Silicon substrate 2 was formed in a quasi-square shape (substantially rectangular shape) with one side length of 125 mm. P+ layer 3 and N+ layer 4 were alternately formed in lines in the back surface of silicon substrate 2, and a silicon oxide film was formed by thermal oxidation as passivation film 5. A silicon nitride film was formed by plasma CVD as antireflection coating 7.

Next, contact holes 6 having a diameter of 0.1 mm were formed with a pitch of 0.3 mm in portions of passivation film 5 directly above P+ layer 3 and N+ layer 4. Contact holes 6 were formed by screen printing and heating a paste mainly composed of phosphoric acid (see Figs. 1 and 2).

Next, N electrode 10 and P electrode contact 8 were formed. P electrode contact 8 was formed in contact hole 6 and N electrode 10 was formed in a shape with a space of about 0.1 mm from P electrode contact 8, each by printing a silver paste into a pattern by screen printing and firing the paste. The silver paste used was mainly composed of silver, and contained several percent of glass frit, and an organic solvent and a thickener for adjusting a viscosity. The glass frit functions to obtain a favorable degree of contact with silicon substrate 2. A heating condition for firing the silver paste was set to a period of 35 seconds at 500°C or more, with a peak temperature of 600°C. As a result of this firing, an organic ingredient in the silver paste was completely decomposed (see Figs. 3 and 4).

Next, a paste mainly composed of a polyimide precursor was applied to a surface ofN electrode 10 to expose only a portion ofN electrode 10 and P electrode contact 8 by screen printing. The paste was then heated for about 15 minutes at a temperature of 250°C, to form insulating layer 11 (see Figs. 5 and 6).

Next, a paste mainly composed of silver was printed by screen printing while being prevented from contacting the exposed portion ofN electrode 10, and the paste was fired to form P electrode 8 (see Figs. 7 and 8). A firing condition was set to a period of 30 seconds at 400°C or more, with a peak temperature of 450°C, so as not to break insulating layer 11. In addition, since the paste was to be fired at a temperature lower than that during firing in the step shown in Fig. 4, the silver paste used did not contain a glass frit and contained only an organic ingredient except silver, in contrast to the silver paste used for forming N electrode 10 and P electrode contact 8. By using such silver paste, low electrical resistivity can be obtained even after firing at a low temperature (see Figs. 8 and 9).

Next, a solar cell module was fabricated by using the solar cells thus manufactured. First, three solar cells 1 were connected in series by means of conducting material 22 including a copper foil covered with solder. Conducting material 22 had a length (120 mm) substantially the same as a width of silicon substrate 2, in order to lower series resistance among solar cells 1.

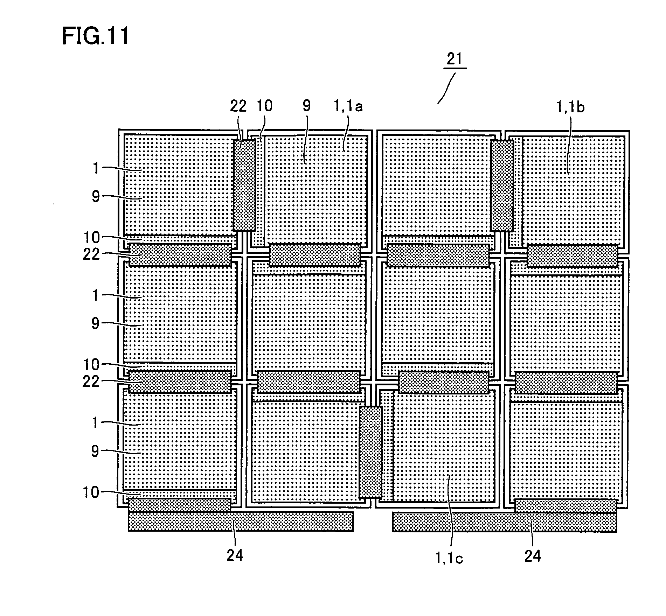

Three solar cells 1 were connected in series in this manner to form one solar cell string, and four solar cell strings were fabricated. Particularly, in three of the four solar cell strings, the series connection was such that a position ofN electrode 10 of one solar cell 1 located at an end was rotated by 90° with respect to a position ofN electrodes 10 of the other two solar cells 1. As a result, the one solar cell 1 could be connected to solar cell 1 in another solar cell string by means of the same conducting material 22 that was used for connection of solar cells 1 in the solar cell string (see Fig. 11).

Consequently, reduction in F.F. caused by use of a busbar could be prevented, as compared to the solar cell strings employing busbar 23 for connection between the solar cell strings (see Fig. 10). In this manner, solar cell string 21 having twelve solar cells 1 connected in series was fabricated (see Fig. 11).

Next, external terminals 24 for external connection were connected to opposing ends of solar cell string 21 having four solar cell strings connected in series. Solar cell string 21 was then inserted into translucent sealant (EVA film) 32. Next, translucent substrate (glass plate) 34 was provided on the side of the light-receiving surface and weather-resistant film 33 was provided on the side of the back surface, and they were heated to seal solar cell string 21 (see Fig. 12). Then, terminal box 3 5 for external connection was connected and frame 36 was attached, to complete the solar cell module (see Fig. 12).

With the method described above, N electrode 10 and P electrode 9 are each formed like a layer, and are formed on substantially the entire back surface of silicon substrate 2 with insulating layer 11 interposed between N electrode 10 and P electrode 9. As a result, solar cell 1 having a very high F.F can be manufactured.

Moreover, such layered N electrode 10, P electrode 9, and insulating layer 11 can be formed very easily with substantially reduced production costs by screen printing, as compared to a case where they are formed through photolithography and a vacuum process.

Furthermore, in solar cell module 31 manufactured by using thus fabricated solar cells 1, solar cells 1 (or solar cell strings) can be wired without a busbar, thereby improving a F.F. of solar cell module 31 as well.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The method for manufacturing a solar cell, the method for manufacturing a solar cell module, and the solar cell module according to the present invention are effectively utilized in photoelectric conversion techniques.

## Claims

1. A method for manufacturing a solar cell, comprising the steps of:
forming a first electrode (10) on a main surface of a silicon substrate (2) by supplying a conducting material;
forming an insulating layer (11) on a surface of said first electrode (10) by applying an insulating material; and
forming a second electrode (9) on a surface of said insulating layer (11) in a manner electrically isolated from said first electrode (10) by supplying a conducting material.

2. The method for manufacturing a solar cell according to claim 1, wherein
in said step of forming said insulating layer (11), one of a screen printing method, an offset printing method, and an ink-jet printing method is applied.

3. The method for manufacturing a solar cell according to claim 1, wherein
said step of forming said insulating layer (11) includes, after the application of said insulating material, the step of heating applied said insulating material or the step of irradiating applied said insulating material with ultraviolet rays.

4. The method for manufacturing a solar cell according to claim 3, wherein
a heating temperature in said heating step is set to 150°C or more and 600°C or less.

5. The method for manufacturing a solar cell according to claim 1, wherein
in said step of forming said insulating layer (11), said insulating layer (11) includes at least one of acryl, epoxy, polyimide, a polyimide precursor, and polyamide-imide as said insulating material.

6. The method for manufacturing a solar cell according to claim 1, wherein
in at least one of said step of forming said first electrode (10) and said step of forming said second electrode (9), one of a screen printing method, an offset printing method, and an ink-jet printing method is applied.

7. The method for manufacturing a solar cell according to claim 6, wherein
at least one of said step of forming said first electrode (10) and said step of forming said second electrode (9) includes the step of applying a silver paste as said insulating material, and heating applied said silver paste.

8. The method for manufacturing a solar cell according to claim 1, wherein said step of forming said first electrode (10) includes a first heating step of heating supplied said conducting material,
said step of forming said second electrode (9) includes a second heating step of heating supplied said conducting material and said first electrode (10) heated in said first heating step, and
a temperature in said second heating step is set to 150°C or more and 600°C or less.

9. A method for manufacturing a solar cell, comprising the steps of:
forming a first electrode (10) on a main surface of a silicon substrate (2) by applying and heating a conducting material, said first electrode (10) being electrically connected to a prescribed region in said silicon substrate (2);
forming an insulating layer (11) on a surface of said first electrode (10) by applying and heating an insulating material; and
forming a second electrode (9) on a surface of said insulating layer (11) by applying and heating a conducting material, said second electrode (9) being electrically isolated from said first electrode (10) and electrically connected to another prescribed region in said silicon substrate (2).

10. The method for manufacturing a solar cell according to claim 9, wherein
in at least one of said step of forming said first electrode (10), said step of forming said second electrode (9), and said step of forming said insulating layer (11), one of a screen printing method, an offset printing method, and an ink-jet printing method is applied.

11. The method for manufacturing a solar cell according to claim 9, wherein
in said step of forming said first electrode (10), a second electrode contact portion electrically connected to said another prescribed region is simultaneously formed, and
in said step of forming said second electrode (9), said second electrode (9) is formed to be electrically connected to said second electrode contact portion (8).

12. The method for manufacturing a solar cell according to claim 9, wherein
in said step of forming said second electrode (9), a silver paste is applied as said conducting material, and
said silver paste contains only an organic ingredient except silver.

13. A solar cell (1) comprising:
a first electrode (10) formed on a main surface of a rectangular silicon substrate (2);
an insulating layer (11) formed on a surface of said first electrode (10) to expose a surface of a portion of a region of said first electrode (10) along a prescribed first side of said rectangular silicon substrate (2); and
a second electrode (9) formed on a surface of said insulating layer (11) in a manner electrically isolated from said first electrode (10),
said insulating layer (11) including at least one material selected from the group consisting of acryl, epoxy, polyimide, a polyimide precursor, and polyamide-imide.

14. A method for manufacturing a solar cell module having the solar cells manufactured by the method for manufacturing a solar cell according to any of claims 1 to 12 connected in series, wherein
a rectangular silicon substrate (2) is used as said silicon substrate (2), and
in said step of forming said insulating layer (11) in each of the plurality of solar cells (1), said insulating layer (11) is formed on a surface of said first electrode (10) to expose a surface of a portion of a region of said first electrode (10) along a prescribed first side of said rectangular silicon substrate (2), said method comprises
a string (21) formation step of forming a first solar cell string (21) and a second solar cell string (21) by connecting a prescribed number of said solar cells (1) in series, respectively, and
a string (21) connection step of connecting said first solar cell string (21) to said second solar cell string (21) in series,
in said string (21) formation step, a first solar cell (1) located at an end in said first solar cell string (21) and a second solar cell (1) located at an end in said second solar cell string (21) are arranged such that said first side of said first solar cell (1) faces a third side or a fourth side other than a second side facing said first side of said second solar cell (1), and
in said string (21) connection step, a portion of a region of said first electrode (10) positioned along said first side of said first solar cell (1) is electrically connected to a portion of said second electrode (9) positioned along said third side or said fourth side of said second solar cell (1) by means of a prescribed conducting member.

15. A solar cell module comprising a plurality of solar cell strings (21) each having a plurality of solar cells connected in series,
each of the plurality of solar cells (1) including
a first electrode (10) formed on a main surface of a rectangular silicon substrate (2),
an insulating layer (11) formed on a surface of said first electrode (10) to expose a surface of a portion of a region of said first electrode (10) along a prescribed first side of said rectangular silicon substrate (2), and
a second electrode (9) formed on a surface of said insulating layer (11) in a manner electrically isolated from said first electrode (10),
in a first solar cell string (21) and a second solar cell string (21) adjacent to each other of the plurality of solar cell strings (21),
a first solar cell (1) located at an end in said first solar cell string (21) and a second solar cell (1) located at an end in said second solar cell string (21) are arranged such that said first side of said first solar cell (1) faces a third side or a fourth side other than a second side facing said first side of said second solar cell (1), and
a portion of a region of said first electrode (10) positioned along said first side of said first solar cell (1) is electrically connected to a portion of said second electrode (9) positioned along said third side or said fourth side of said second solar cell (1) by means of a prescribed conducting member.
